# EUROPÄISCHE PATENTSCHRIFT

(11) **EP 3 666 049 B1**
(45) Veröffentlichungstag und Bekanntmachung des Hinweises auf die Patenterteilung: **29.09.2021**
(21) Anmeldenummer: 17758083.4
(22) Anmeldetag: 10.08.2017
(51) Int. Cl.: H05K 13/00

(54) **KLEMMRAHMEN UND TRANSPORTVORRICHTUNG ZUM TRANSPORT VON SUBSTRATEN**
CLAMPING FRAME AND TRANSPORT DEVICE FOR TRANSPORTING SUBSTRATES
CADRE DE SERRAGE ET DISPOSITIF DE TRANSPORT SERVANT AU TRANSPORT DE SUBSTRATS

(43) Veröffentlichungstag der Anmeldung: 17.06.2020
(73) Patentinhaber: Gebr. Schmid GmbH, 72250 Freudenstadt (DE)
(72) Erfinder: SCHUSTER, Marc, 72250 Freudenstadt (DE)
(74) Vertreter: Patentanwälte Ruff, Wilhelm, Beier, Dauster & Partner mbB
(86) Internationale Anmeldenummer: PCT/EP2017/070333
(87) Internationale Veröffentlichungsnummer: WO 2019/029813

(56) Entgegenhaltungen:
- EP-A1- 0 652 698
- EP-A2- 0 480 585
- DE-A1- 3 625 038
- US-A- 6 112 885

## Beschreibung

Die Erfindung betrifft einen Klemmrahmen zum Transport von dünnen flächigen Substraten, insbesondere Leiterplatten, und eine damit ausgerüstete Transportvorrichtung.

Bei der Bearbeitung von dünnen flächigen Substraten wie beispielsweise Leiterplatten in der Leiterplattenindustrie oder Dünnschichtsolarzellen findet eine Behandlung oftmals in einer nasschemischen Prozesslinie statt, z.B. für einen Ätzprozess. Dabei ist es aus der EP 0 718 871 A2 bekannt, die Substrate auf Rollen oder Walzenbahnen aufzulegen und durch eine Behandlungseinrichtung hindurch zu transportieren. Mit zunehmend dünner werdenden Substraten, insbesondere Leiterplatten, die schon folienartig sind, wird dies jedoch immer schwieriger. Die Substrate weisen nicht genügend Eigenstabilität auf oder können aufgrund des sehr geringen Gewichts durch Besprühen mit Ätzflüssigkeit oder dgl. bewegt oder verschoben werden. Des Weiteren sind die Oberflächen mancher Substrate derart empfindlich, dass sie bereits durch das Aufliegen auf den Rollen beschädigt werden könnten.

Um eine Beschädigung der Oberflächen der dünnen flächigen Substrate zu vermeiden, können diese von einem Halter und/oder Halterahmen gehalten und zusammen mit diesem Halter und/oder Halterahmen durch eine Behandlungseinrichtung hindurch transportiert werden. Hierfür sind unterschiedliche Ausführungsformen des Halters und/oder Halterahmens bekannt.

So ist in der DE 10 2007 038 116 A1 eine Transportvorrichtung offenbart, bei der das Substrat entlang einer Körperkante zwischen zwei Halteteilen kraftschlüssig gehalten wird. Die kraftschlüssige Verbindung kann durch eine Verschraubung oder mittels Magneten hergestellt werden. Die Halteteile, die das Substrat halten, sind mit der Transportvorrichtung verbunden, die das Substrat einer Behandlungseinrichtung zuführt.

In der DE 10 2009 049 905 A1 ist ein Halterahmen beschrieben, der Substrate mittels einer durchgehenden Klemmstange, die Klemmnasen aufweist, hält und in Verbindung mit Transportketten das Substrat transportieren kann.

Des Weiteren ist in der DE 101 31 945 A1 eine Transportvorrichtung offenbart, bei der die Substrate in U-förmigen einteiligen Klemmeinheiten gehalten werden. Die benötigte Klemmwirkung wird durch die federnde Eigenschaft der U-Form der Klemmeinheiten erreicht.

In der DE 43 37 811 A1 ist eine Transportvorrichtung offenbart, bei der die Substrate mittels einer Andruckfeder gegen eine Anlageplatte geklemmt werden. EP0480585 offenbart eine weitere Vorrichtung zur Förderung von Leiterplatten.

Der Erfindung liegt die Aufgabe zugrunde, einen Klemmrahmen zum sicheren Haltern von dünnen flächigen Substraten, insbesondere Leiterplatten und dgl., der sich mit vergleichsweise geringem Aufwand realisieren lässt, und eine damit ausgerüstete Transportvorrichtung bereitzustellen.

Gelöst wird diese Aufgabe von der Erfindung durch die Bereitstellung eines Klemmrahmens mit den Merkmalen des Anspruchs 1 sowie einer Transportvorrichtung mit den Merkmalen des Anspruchs 10. Vorteilhafte sowie bevorzugte Ausgestaltungen der Erfindung sind Gegenstand der weiteren Ansprüche.

Erfindungsgemäß weist der Klemmrahmen mindestens ein Klemmhaltemittel und einen Rahmenkörper mit mindestens einer Klemmleiste auf. Insbesondere kann der Klemmrahmen eine Mehrzahl von Klemmhaltemittel aufweisen, wie drei, vier, acht oder mehr als acht Klemmhaltemittel. Das Klemmhaltemittel umfasst ein erstes Klemmglied, ein zweites Klemmglied, ein Drehgelenk und ein elastisches Element. Das erste Klemmglied weist einen Klemmabschnitt und einen Bedienabschnitt auf. Das Drehgelenk unterteilt das erste Klemmglied in den Klemmabschnitt und den Bedienabschnitt. Das zweite Klemmglied ist an der Klemmleiste des Rahmenkörpers angeordnet. Der Klemmabschnitt des ersten Klemmglieds liegt dem zweiten Klemmglied gegenüber und wirkt mit diesem unter Bildung eines zwischenliegenden Klemmspalts zusammen. Das Drehgelenk verbindet schwenkbeweglich das zweite Klemmglied mit dem ersten Klemmglied, z.B. mittels einer kraftschlüssigen oder formschlüssigen Verbindung.

Das elastische Element spannt den Klemmabschnitt des ersten Klemmglieds gegen das zweite Klemmglied klemmspaltverengend vor. Dazu kann das elastische Element eine entsprechende Vorspannkraft direkt auf den Klemmabschnitt oder alternativ auf den Bedienabschnitt des ersten Klemmglieds ausüben. In letzterem Fall wird die Vorspannkraft über das Drehgelenk vom Bedienabschnitt auf den Klemmabschnitt übertragen. Das Klemmhaltemittel kann eine Aufnahme für das elastische Element aufweisen.

Damit ermöglicht die Erfindung eine funktionssichere Handhabung von Substraten sowie je nach Bedarf eine vereinfachte Montage des Klemmrahmens, eine Reduktion der Herstellkosten und eine Reduktion der Bauteilanzahl.

Das Substrat kann z.B. durch eine kraftschlüssige Verbindung im Klemmspalt gehalten werden. Die Klemmkraft kann insbesondere die durch das elastische Element erzeugte Vorspannkraft sein. Um die Wirkung der kraftschlüssigen Verbindung zwischen dem Substrat und den beiden Klemmgliedern zu verbessern, kann bei Bedarf eine Substratkontaktfläche des Klemmabschnitts des ersten Klemmglieds und/oder eine Substratkontaktfläche des zweiten Klemmglieds, die in mechanischen Kontakt mit dem Substrat kommt, in ihrer Form optimiert werden.

In einem nicht klemmenden Zustand des Klemmhaltemittels kann das Substrat in den Klemmrahmen eingesetzt und wieder aus ihm herausgenommen werden und in einem klemmenden Zustand des Klemmhaltemittels kann das Substrat im Klemmrahmen festgeklemmt gehalten werden. Um das Klemmhaltemittel vom klemmenden Zustand in den nicht klemmenden Zustand überzuführen, kann der Klemmabschnitt oder der Bedienabschnitt des ersten Klemmglieds mit einer Gegenkraft klemmspaltvergrößernd beaufschlagt werden, die der Vorspannkraft des elastischen Elements entgegenwirkt. Diese Gegenkraft kann von einer Bedienperson und/oder einer Vorrichtung auf das Klemmhaltemittel ausgeübt werden. Hierfür kann das erste Klemmglied optional eine besonders gestaltete Betätigungsoberfläche aufweisen. Diese Betätigungsoberfläche kann das Ausüben der benötigten Gegenkraft erleichtern und ein ungewolltes Abrutschen verhindern.

In einer Ausgestaltung der Erfindung verbindet das Drehgelenk das erste Klemmglied lösbar mit dem zweiten Klemmglied. Die lösbare Verbindung ermöglicht eine einfache Montage bzw. einen einfachen Austausch des ersten Klemmglieds. Ein weiterer Vorteil ist, dass je nach Bedarf nicht alle zweiten Klemmglieder mit einem ersten Klemmglied verbunden sein müssen und/oder die Anzahl und/oder Konfiguration der ersten Klemmglieder verändert werden kann. Dadurch kann z.B. die Anzahl der ersten Klemmglieder an unterschiedliche Substratgrößen angepasst werden, indem erste Klemmglieder entfernt werden, die keinen Kontakt zum Substrat haben, oder zusätzliche erste Klemmglieder angebracht werden. Die Anzahl der ersten Klemmglieder an der jeweiligen Klemmleiste kann folglich variabel an die Anforderungen des Haltens und des Transportierens des Substrats und/oder an die Anforderungen eines nachfolgenden Prozesses angepasst werden, den das Substrat durchläuft. Die zweiten Klemmglieder, an denen kein erstes Klemmglied angebracht ist, können das Substrat im Fall eines im Wesentlichen horizontalen Transports als Auflagen stützen.

In einer vorteilhaften Weiterbildung der Erfindung weist das Drehgelenk einen drehwellenartigen Fortsatz an dem einen Klemmglied und eine korrespondierende Ausnehmung an dem anderen Klemmglied auf. Beispielsweise kann das Drehgelenk durch einen Fortsatz gebildet sein, der abschnittsweise einen kreisbogenförmigen Querschnitt aufweist. Der Fortsatz kann sich an dem ersten Klemmglied befinden und passt dann in eine korrespondierende Ausnehmung des zweiten Klemmglieds oder des Klemmrahmens. Alternativ kann er sich an dem zweiten Klemmglied oder an einer anderen Stelle des Klemmrahmens befinden und in eine korrespondierende Ausnehmung des ersten Klemmglieds passen.

In einer Ausgestaltung der Erfindung ist das zweite Klemmglied mit der Klemmleiste lösbar verbunden. So kann bei Bedarf das zweite Klemmglied an der Klemmleiste angebracht und auch wieder abgenommen werden. Der Bauteileinsatz wird dadurch optimiert.

In einer alternativen, fertigungs- und montagetechnisch vorteilhaften Ausgestaltung der Erfindung ist das zweite Klemmglied ein einstückiger Abschnitt der Klemmleiste. Das minimiert die Anzahl erforderlicher Einzelbauteile.

In entsprechenden Ausgestaltungen der Erfindung weist der Rahmenkörper mindestens eine Verbindungsleiste auf, die mehrteilig und in ihrer Länge einstellbar ist, und/oder die Klemmleiste ist mehrteilig und in ihrer Länge einstellbar. Auf diese Weise kann der Klemmrahmen in seiner Größe eingestellt und an Substrate unterschiedlicher Größen angepasst werden, um diese zu halten. Die mehrteilige Klemmleiste und/oder mehrteilige Verbindungsleiste kann eine Dehnfuge aufweisen, die bei Bedarf einen thermischen Längenausgleich ermöglicht. Das Material der Verbindungsleiste und/oder Klemmleiste kann z.B. ein Kunststoff, insbesondere PVC, oder ein Metall, insbesondere Titan, oder eine Kombination solcher Materialien sein.

In einer Ausgestaltung der Erfindung ist das elastische Element eine Feder oder ein Gummielement. Die Feder kann insbesondere eine Schraubenfeder oder Biegefeder sein. Das Gummielement kann insbesondere ein Gummizug oder Gummiband sein.

In einer weiteren, vorteilhaft einfachen Ausgestaltung der Erfindung ist das Gummielement ein O-Ring. Der Querschnitt des O-Rings kann eine an seine Funktion angepasste Form aufweisen.

In einer weiteren Ausgestaltung der Erfindung weist das erste und/oder das zweite Klemmglied eine Aufnahmenut für das elastische Element auf, z.B. zur Aufnahme eines O-Rings als elastisches Element. Dies unterstützt einen sicheren Halt des elastischen Elements am betreffenden Klemmglied. Die Aufnahmenut kann eine Form aufweisen, die an die Form des Querschnittes und/oder an die Form der Auflagefläche des elastischen Elements angepasst ist.

In einer Ausgestaltung der Erfindung ist der Klemmrahmen rechteckig. Hierfür sind zwei Verbindungsleisten sich gegenüberliegend angeordnet und es sind zwei Klemmleisten sich gegenüberliegend angeordnet. Diese vier Leisten bilden zusammen den Klemmrahmen. Die zweiten Klemmglieder sind in Richtung der gegenüberliegenden Klemmleiste orientiert, indem sie z.B. in eine von dem Klemmrahmen gebildete Öffnung hinein von der betreffenden Klemmleiste abstehen. Damit kann ein Substrat in der Öffnung gehalten werden. Die zwei Klemmleisten weisen eine Mehrzahl der zweiten Klemmglieder auf, wobei die zweiten Klemmglieder in Richtung der gegenüberliegenden Klemmleiste orientiert sind. Die ersten Klemmglieder sind separate Bauteile und an allen oder an einem Teil der zweiten Klemmglieder der Klemmleisten zur Bildung des zugehörigen Klemmhaltemittels angebracht.

Die erfindungsgemäße Transportvorrichtung weist mindestens einen erfindungsgemäßen Klemmrahmen und ein Rahmenfördermittel auf, das in Transportrichtung der Substrate umläuft und mit dem Klemmrahmen verbunden ist. Durch die umlaufend arbeitende Transportvorrichtung kann das Substrat besonders effizient einer Bearbeitungsanlage oder Bearbeitungsstation zugeführt und/oder durch eine solche hindurchgeführt werden.

Vorteilhafte Ausführungsformen der Erfindung sind in den Zeichnungen dargestellt und werden nachfolgend beschrieben. Hierbei zeigen:
- Fig. 1: eine Perspektivansicht eines Klemmrahmens mit Klemmhaltemitteln,
- Fig. 2: eine Ausschnittansicht eines Bereichs A von Fig. 1, die ein einzelnes Klemmhaltemittel zeigt,
- Fig. 3: eine Seitenansicht des Klemmhaltemittels von Fig. 2 und
- Fig. 4: eine ausschnittweise Perspektivansicht einer Variante des Klemmrahmens der Fig. 1 bis 3.

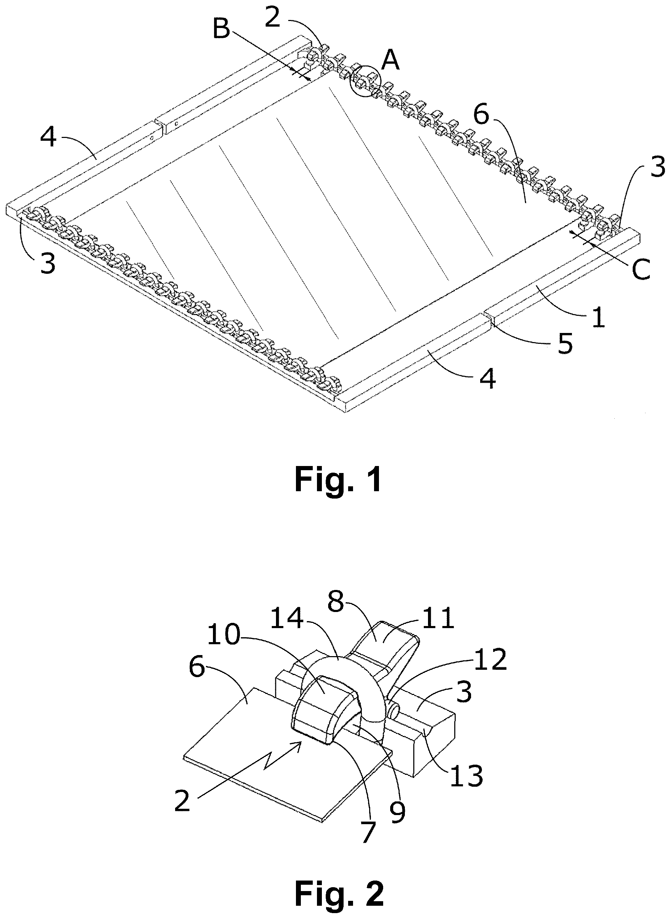

Der erfindungsgemäße Klemmrahmen dient dazu, dünne flächige Substrate, insbesondere Leiterplatten, zu halten und den Transport von Substraten mit einer Transportvorrichtung zu ermöglichen. Entsprechend zeigen die Fig. 1 bis 3 einen Klemmrahmen, in dem ein Substrat 6 gehalten ist. Um das im Klemmrahmen gehaltene Substrat 6 zu bewegen, ist der Klemmrahmen Bestandteil einer Transportvorrichtung von herkömmlicher Bauart, die hier nicht weiter gezeigt ist. Der Klemmrahmen weist einen Rahmenkörper 1 auf, der über mindestens eine Klemmleiste 3 verfügt. In dem gezeigten Ausführungsbeispiel weist der Klemmrahmen zwei Klemmleisten 3 auf. Des Weiteren weist der Klemmrahmen mindestens ein Klemmhaltemittel 2 zum Halten des Substrats 6 auf, wobei das gezeigte Beispiel über mehrere Klemmhaltemittel 2 verfügt.

Das jeweilige Klemmhaltemittel 2 setzt sich aus einem ersten Klemmglied 8, einem zweiten Klemmglied 9, einem Drehgelenk und einem elastischen Element 14 zusammen, wobei das Drehgelenk von zugehörigen Teilen des ersten und des zweiten Klemmglieds 8, 9 gebildet ist. Das erste Klemmglied 8 weist einen Klemmabschnitt 10 und einen Bedienabschnitt 11 auf. Das zweite Klemmglied 9 ist an der Klemmleiste 3 des Rahmenkörpers 1 angeordnet und der Klemmabschnitt 10 des ersten Klemmglieds 8 liegt dem zweiten Klemmglied 9 gegenüber, wobei das zweite Klemmglied 9 mit dem ersten Klemmglied 8 zusammenwirkt. Das Drehgelenk verbindet schwenkbeweglich das zweite Klemmglied 9 mit dem ersten Klemmglied 8 unter Bildung eines Klemmspalts 7. Das elastische Element 14 spannt den Klemmabschnitt 10 des ersten Klemmglieds 8 gegen das zweite Klemmglied 9 klemmspaltverengend vor.

Im gezeigten Beispiel ist an jeder Klemmleiste 3 eine Mehrzahl von zweiten Klemmgliedern 9 einteilig in einer Reihe nebeneinanderliegend angeformt. Dabei weisen die zweiten Klemmglieder 9 eine Breite B auf und haben einen Abstand C voneinander, der vorzugsweise größer ist als die Breite B.

In dem gezeigten Ausführungsbeispiel der Fig. 1 bis 3 stellt das Drehgelenk eine lösbare Verbindung zwischen dem ersten Klemmglied 8 und dem zweiten Klemmglied 9 dar. Das Drehgelenk beinhaltet einen drehwellenartigen Fortsatz 12 an dem ersten Klemmglied 8 und eine korrespondierende Ausnehmung 13 an dem zweiten Klemmglied 9, in die der Fortsatz 12 passt. Das Drehgelenk bzw. dessen Fortsatz 12 unterteilt das erste Klemmglied 8 in den Klemmabschnitt 10 und den Bedienabschnitt 11. Der drehwellenartige Fortsatz 12 weist im Querschnitt die Form eines Kreisbogens auf und steht über die beiden äußeren Flanken des ersten Klemmglieds 8 axial vor. Die Ausnehmung 13 weist einen korrespondierenden kreisbogenförmigen Querschnitt auf. In dem gezeigten Ausführungsbeispiel ist die korrespondierende Ausnehmung 13 von einer über die Länge der Klemmleiste 3 hinweg durchgehend in der Klemmleiste 3 ausgebildeten Nut bereitgestellt.

Des Weiteren ist der Rahmenkörper 1 in dem gezeigten Ausführungsbeispiel der Fig. 1 bis 3 rechteckig und weist zwei sich gegenüberliegende Verbindungsleisten 4 auf. Diese sind mit den beiden sich gegenüberliegenden Klemmleisten 3 z.B. jeweils einteilig verbunden. Die Verbindungsleisten 4 sind bevorzugt aus mehreren teleskopartig ausund einziehbaren Teilen zusammengesetzt und dadurch in ihrer Länge einstellbar. In dem gezeigten Ausführungsbeispiel weist jede Verbindungsleiste 4 eine Dehnfuge 5 auf, um thermische Ausdehnungseffekte der Verbindungsleisten 4 zu kompensieren.

In einer nicht gezeigten Variation des erfindungsgemäßen Klemmrahmens kann mindestens eine Klemmleiste 3 in analoger Weise mehrteilig ausgeführt sein, um sie in ihrer Länge variabel verändern zu können.

In dem gezeigten Ausführungsbeispiel der Fig. 1 bis 3 ist das elastische Element 14 ein O-Ring, der aus Gummi besteht. Dabei spannt das elastische Element 14 den Klemmabschnitt des ersten Klemmglieds 8 gegen das zweite Klemmglied 9 durch eine Vorspannkraft klemmspaltverengend vor. An dem zweiten Klemmglied 9 ist eine Aufnahmenut 15 angebracht, die den O-Ring daran hindert, vom Klemmhaltemittel 2 abzurutschen und dadurch das Klemmhaltemittel 2 nicht mehr vorzuspannen. Des Weiteren ist das erste Klemmglied 8, an dem der O-Ring angreift, so geformt, dass sich der Angriffspunkt des O-Rings am ersten Klemmglied 8 in Richtung des Drehgelenks 12 verlagert, wenn sich der O-Ring ungewollt aus seiner montierten Lage unter Verringerung seines Ringdurchmessers bewegt.

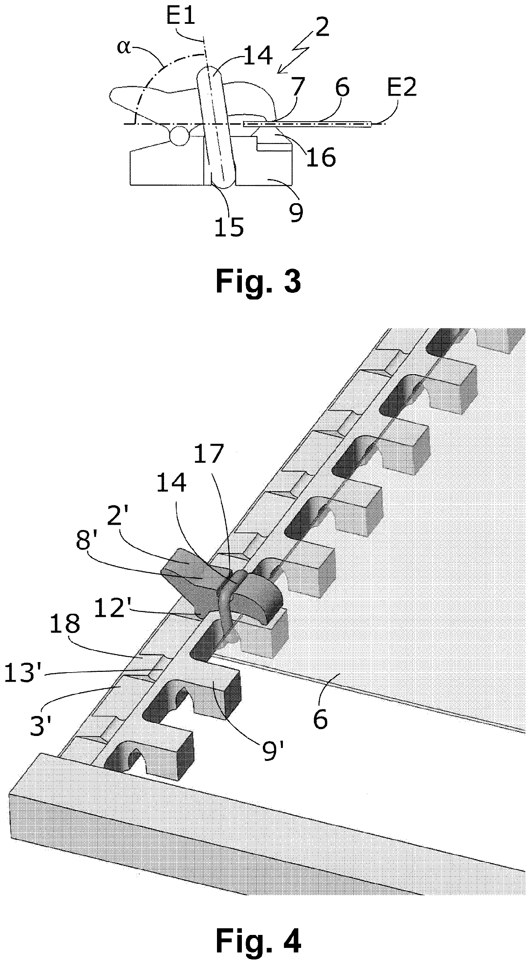

Insbesondere aus Fig. 3 ist ersichtlich, dass der O-Ring in einer Ebene E1 liegt, die schräg zu einer Substratfläche bzw. Rahmenöffnungsebene E2 orientiert ist, d. h. mit dieser einen Winkel α größer als 0° und kleiner als 90° einschließt, wobei der Winkel α z. B. im Bereich zwischen 60° und 86° liegt.

Des Weiteren sind die ersten Klemmglieder 8 in dem gezeigten Ausführungsbeispiel der Fig. 1 bis 3 als separate Bauteile ausgeführt und für alle zweiten Klemmglieder 9 des Klemmrahmens ist je ein erstes Klemmglied 8 montiert. Dabei werden die separaten ersten Klemmglieder 8 jeweils durch das elastische Element 14 an dem zugehörigen zweiten Klemmglied 9 gehalten.

Der Klemmrahmen bildet eine Öffnung, in der das Substrat 6 gehalten ist. Die zweiten Klemmglieder 9 der Klemmhaltemittel 2 sind so orientiert, dass sie in die Öffnung hineinragen und in Richtung der gegenüberliegenden Klemmleiste 3 zeigen. Das Substrat 6 wird durch die von dem elastischen Element 14 aufgebrachte Klemmkraft sicher im Klemmspalt 7 der Klemmhaltemittel 2 gehalten. Zum Ein- und Ausbauen des Substrats 6 in das Klemmhaltemittel 2 bzw. aus diesem heraus, wird eine der Vorspannkraft des elastischen Elements 14 entgegenwirkende Gegenkraft auf den Bedienabschnitt 11 ausgeübt. Durch das Drehgelenk wird das erste Klemmglied 8 relativ zum zweiten Klemmglied 9 klemmspaltvergrößernd verschwenkt und das Substrat 6 kann aus dem geöffneten Klemmspalt 7 entnommen bzw. in diesen eingesetzt werden.

Um die Klemmwirkung zu unterstützen, kann das zweite Klemmglied 9 und/oder das erste Klemmglied 8 eine dafür speziell gestaltete Form aufweisen, z. B. indem Kontaktflächen, mit denen das Klemmhaltemittel 2 gegen das Substrat 6 zur Anlage kommt, in ihrer Form optimiert sind. So verfügt das zweite Klemmglied 9 in dem gezeigten Ausführungsbeispiel der Fig. 1 bis 3 über einen Kontaktabschnitt 16, der die Kontaktfläche zum Substrat 6 reduziert. Korrespondierend ist das erste Klemmglied 8 derart gestaltet, dass sein Kontakt mit dem Substrat 6 demjenigen des Kontaktabschnitts 16 mit dem Substrat 6 genau gegenüberliegt. Hierfür ist eine schnabelförmige Ausgestaltung des ersten Klemmglieds 8 vorteilhaft, wie sie aus Fig. 3 ersichtlich ist.

In Fig. 4 ist ein Ausschnitt einer Variante des Klemmrahmens der Fig. 1 bis 3 in Perspektivansicht dargestellt, wobei zum leichteren Verständnis für identische oder funktionell äquivalente Elemente sich entsprechende Bezugszeichen verwendet sind und diesbezüglich auch auf die obigen Erläuterungen zum Ausführungsbeispiel der Fig. 1 bis 3 verwiesen werden kann. In dieser Ausführung steht ein insoweit modifizierter drehwellenartiger Fortsatz 12' des Drehgelenks nicht über die Flanken des ersten Klemmglieds 8' heraus. Zur Aufnahme des modifizierten drehwellenartigen Fortsatzes 12' sind korrespondierende individuelle Ausnehmungen bzw. Nuten 13' in einer zugehörigen Erhöhung 18 der Klemmleiste 3' gebildet. In dem gezeigten Ausführungsbeispiel ist die Breite der Erhöhung 18 im Bereich der Breite der zweiten Klemmglieder 9'. Wie in der Ausführungsvariante der Fig. 1 bis 3 sind zweite Klemmglieder 9' einteilig an der Klemmleiste 3' angeformt. Die zweiten Klemmglieder 9' aus Fig. 4 sind oberseitig flach, d. h. ohne den reduzierten Kontaktabschnitt 16. Des Weiteren ist im gezeigten Fall von Fig. 4 nur für eines der zweiten Klemmglieder 9' ein erstes Klemmglied 8' zur Bildung eines entsprechenden Klemmhaltemittels 2' montiert, wobei letzteres eine Aufnahmenut 17 für das elastisches Element 14 aufweist. In der gezeigten Ausführung ist in dieser Aufnahmenut 17 der O-Ring als das elastische Element 14 gehalten. Die jeweiligen zweiten Klemmglieder 9', für die kein erstes Klemmglied 8' montiert ist, dienen einem geklemmt gehaltenen Substrat 6 als im Wesentlichen horizontale Auflage.

In einer nicht gezeigten Variante des erfindungsgemäßen Klemmrahmens sind die zweiten Klemmglieder als von der Klemmleiste getrennte Bauteile realisiert, die lösbar mit der Klemmleiste verbunden werden können. Dadurch kann der Bauteileinsatz optimiert werden, indem nur die tatsächlich zu Substratklemmzwecken erforderlichen zweiten Klemmglieder an der Klemmleiste montiert werden.

Des Weiteren kann in nicht gezeigten Varianten des erfindungsgemäßen Klemmrahmens das elastische Element welches die beiden Klemmglieder vorspannt, eine Feder, wie z. B. eine Zug-, Druck- oder eine Spiralfeder, sein.

Der erfindungsgemäße Klemmrahmen ist geeignet und dafür ausgelegt, mit einem herkömmlichen Rahmenfördermittel verbunden zu werden und damit eine Transportvorrichtung für das Substrat bereitzustellen. So kann die Klemmleiste oder die Verbindungsleiste ein Verbindungsmittel aufweisen, um den Klemmrahmen an z. B. umlaufenden Transportketten montieren zu können, so dass die Transportketten den Klemmrahmen zusammen mit dem Substrat in eine z.B. horizontale Transportrichtung befördern. Durch die Transportvorrichtung kann das im Klemmrahmen gehaltene Substrat, bzw. mehrere solche flachen Substrate in hintereinander angeordneten Klemmrahmen, einer Behandlungseinrichtung zugeführt und/oder durch die Behandlungseinrichtung hindurchgeleitet werden.

Wie die oben erläuterten Ausführungsbeispiele deutlich machen, stellt die Erfindung einen Klemmrahmen für eine funktionssichere Handhabung von Substraten zur Verfügung, der in sehr vorteilhafter Weise nur eine geringe Anzahl von einfach herstellbaren Bauteilen benötigt und somit eine vereinfachte Montage und eine bedarfsgerechte Modifikation des Klemmrahmens erlaubt. Die Herstellkosten können durch die geringe Anzahl von Bauteilen gering gehalten werden.

## Patentansprüche

1. Klemmrahmen für eine Transportvorrichtung zum Transport von dünnen flächigen Substraten (6), insbesondere Leiterplatten, mit
- einem Rahmenkörper (1), der mindestens eine Klemmleiste (3) aufweist, und
- mindestens einem Klemmhaltemittel (2) mit
- einem ersten Klemmglied (8), das einen Klemmabschnitt (10) und einen Bedienabschnitt (11) aufweist,
- einem zweiten Klemmglied (9), das an der Klemmleiste des Rahmenkörpers angeordnet ist und dem Klemmabschnitt des ersten Klemmglieds gegenüberliegt und mit dem ersten Klemmglied zusammenwirkt,
- einem Drehgelenk, welches das erste Klemmglied in den Klemmabschnitt und den Bedienabschnitt unterteilt und das zweite Klemmglied mit dem ersten Klemmglied unter Bildung eines Klemmspalts (7) schwenkbeweglich verbindet, und
- einem elastischen Element (14), das den Klemmabschnitt des ersten Klemmglieds gegen das zweite Klemmglied klemmspaltverengend vorspannt.

2. Klemmrahmen nach Anspruch 1, **dadurch gekennzeichnet, dass** das Drehgelenk das erste Klemmglied lösbar mit dem zweiten Klemmglied verbindet.

3. Klemmrahmen nach einem der vorhergehenden Ansprüche, **dadurch gekennzeichnet, dass** das Drehgelenk einen drehwellenartigen Fortsatz (12) an dem einen Klemmglied und eine korrespondierende Ausnehmung (13) an dem anderen Klemmglied aufweist.

4. Klemmrahmen nach einem der vorhergehenden Ansprüche, **dadurch gekennzeichnet, dass** das zweite Klemmglied mit der Klemmleiste lösbar verbunden ist.

5. Klemmrahmen nach Anspruch 1 bis 3, **dadurch gekennzeichnet, dass** das zweite Klemmglied ein einstückiger Abschnitt der Klemmleiste ist.

6. Klemmrahmen nach einem der vorhergehenden Ansprüche, **dadurch gekennzeichnet, dass**
- der Rahmenkörper mindestens eine Verbindungsleiste (4) aufweist, die mehrteilig ist und in ihrer Länge einstellbar ist, und/oder
- die Klemmleiste mehrteilig ist und in ihrer Länge einstellbar ist.

7. Klemmrahmen nach einem der vorhergehenden Ansprüche, **dadurch gekennzeichnet, dass** das elastische Element eine Feder oder ein Gummielement ist.

8. Klemmrahmen nach Anspruch 7, **dadurch gekennzeichnet, dass**
- das Gummielement ein O-Ring ist und/oder
- das erste und/oder das zweite Klemmglied eine Aufnahmenut (15, 17) für das elastische Element aufweist.

9. Klemmrahmen nach einem der vorhergehenden Ansprüche, **dadurch gekennzeichnet, dass**
- der Klemmrahmen rechteckig ist und zwei gegenüberliegende Verbindungsleisten und zwei gegenüberliegende Klemmleisten aufweist,
- die zwei Klemmleisten jeweils eine Mehrzahl der zweiten Klemmglieder aufweisen, wobei die zweiten Klemmglieder in Richtung der gegenüberliegenden Klemmleiste orientiert sind, und
- die ersten Klemmglieder separate Bauteile sind, die an allen oder an einem Teil der zweiten Klemmglieder der Klemmleisten zur Bildung des zugehörigen Klemmhaltemittels angebracht sind.

10. Transportvorrichtung zum Transport von dünnen flächigen Substraten, insbesondere Leiterplatten, aufweisend
- mindestens einen Klemmrahmen nach einem der vorhergehenden Ansprüche und
- ein Rahmenfördermittel, das in einer Transportrichtung der Substrate umläuft und mit dem Klemmrahmen verbunden ist.

## Claims

1. Clamping frame for a transport device for transporting thin flat substrates (6), in particular circuit boards, having
- a frame body (1) including at least one clamping strip (3), and
- at least one clamping holding means (2) having
- a first clamping member (8) which includes a clamping portion (10) and an operating portion (11),
- a second clamping member (9) which is disposed on the clamping strip of the frame body and is located opposite the clamping portion of the first clamping member and cooperates with the first clamping member,
- a pivot joint which subdivides the first clamping member in the clamping portion and the operating portion and connects the second clamping member to the first clamping member in a pivoting manner thereby forming a clamping gap (7), and
- an elastic element (14) to pretension the clamping portion of the first clamping member against the second clamping member in narrowing the clamping gap.

2. Clamping frame according to claim 1, **characterized in that** the pivot joint connects the first clamping member detachably to the second clamping member.

3. Clamping frame according to any of the preceding claims, **characterized in that** the pivot joint has a rotary shaft-type extension (12) on the one clamping member and a corresponding recess (13) on the other clamping member.

4. Clamping frame according to any of the preceding claims, **characterized in that** the second clamping member is detachably connected to the clamping strip.

5. Clamping frame according to any of claims 1 to 3, **characterized in that** the second clamping member is an integral portion of the clamping strip.

6. Clamping frame according to any of the preceding claims, **characterized in that**
- the frame body includes at least one connecting strip (4) which has a multi-part design and is adjustable in length, and/or
- the clamping strip has a multi-part design and is adjustable in length.

7. Clamping frame according to any of the preceding claims, **characterized in that** the elastic element is a spring or a rubber element.

8. Clamping frame according to claim 7, **characterized in that**
- the rubber element is an O-ring, and/or
- the first and/or the second clamping member includes a mounting groove (15, 17) for the elastic element.

9. Clamping frame according to any of the preceding claims, **characterized in that**
- the clamping frame is rectangular and has two opposed connecting strips and two opposed clamping strips,
- the two clamping strips each include a plurality of the second clamping members, wherein the second clamping members are oriented in the direction towards the opposite connecting strip, and
- the first clamping members are separate components which are attached to all or to a part of the second clamping members of the clamping strips for forming the associated clamping holding means.

10. Transport device for transporting thin flat substrates, in particular circuit boards, having
- at least one clamping frame according to any of the preceding claims, and
- a frame conveyance means which circulates in a transporting direction of the substrates and is connected to the clamping frame.

## Revendications

1. Cadre de serrage pour un dispositif de transport servant au transport de substrats minces plats (6), en particulier de plaquettes de circuits, avec
- un corps de cadre (1) présentant au moins une barrette de serrage (3), et
- au moins un moyen de retenue de serrage (2) avec
- un premier élément de serrage (8) présentant une section de serrage (10) et une section de commande (11),
- un deuxième élément de serrage (9) arrangé sur la barrette de serrage du corps de cadre et opposé à la section de serrage du premier élément de serrage et coopérant avec le premier élément de serrage,
- une articulation pivotante subdivisant le premier élément de serrage en la section de serrage et la section de commande et connectant le deuxième élément de serrage au premier élément de serrage en formant une fente de serrage (7) en pivotement, et
- un élément élastique (14) effectuant un préserrage de la section de serrage du premier élément de serrage contre le deuxième élément de serrage en contractant la fente de serrage.

2. Cadre de serrage selon la revendication 1, **caractérisé en ce que** l'articulation pivotante relie le premier élément de serrage au deuxième élément de serrage de manière amovible.

3. Cadre de serrage selon l'une quelconque des revendications précédentes, **caractérisé en ce que** l'articulation pivotante présente un prolongement de type arbre rotatif (12) sur l'un élément de serrage et un renfoncement (13) correspondant sur l'autre élément de serrage.

4. Cadre de serrage selon l'une quelconque des revendications précédentes, **caractérisé en ce que** le deuxième élément de serrage est relié à la barrette de serrage de manière amovible.

5. Cadre de serrage selon l'une quelconque des revendications 1 à 3, **caractérisé en ce que** le deuxième élément de serrage fait une partie intégrale de la barrette de serrage.

6. Cadre de serrage selon l'une quelconque des revendications précédentes, **caractérisé en ce que**
- le corps de cadre présente au moins une barrette de connexion (4) qui comprend plusieurs parties et est ajustable en longueur, et/ou
- la barrette de serrage comprend plusieurs parties et est ajustable en longueur.

7. Cadre de serrage selon l'une quelconque des revendications précédentes, **caractérisé en ce que** l'élément élastique est un ressort ou un élément en caoutchouc.

8. Cadre de serrage selon la revendication 7, **caractérisé en ce que**
- l'élément en caoutchouc est un joint torique et/ou
- le premier et/ou le deuxième élément de serrage présente une rainure de logement (15, 17) pour l'élément élastique.

9. Cadre de serrage selon l'une quelconque des revendications précédentes, **caractérisé en ce que**
- le cadre de serrage est rectangulaire et présente deux barrettes de connexion opposées et deux barrettes de serrage opposées,
- chacune des deux barrettes de serrage présente une pluralité de deuxièmes éléments de serrage, lesdites deuxièmes éléments de serrage étant orientés vers la barrette de serrage opposée, et
- les premiers éléments de serrage sont des composants particuliers, qui sont attachés à tous ou une partie des deuxièmes éléments de serrage des barrettes de serrage pour la formation du moyen de retenue de serrage associé.

10. Dispositif de transport servant au transport de substrats minces plats, en particulier de plaquettes de circuits, comprenant
- au moins un cadre de serrage selon l'une quelconque des revendications précédentes et
- un moyen convoyeur de cadre circulant dans une direction de transport des substrats et relié au cadre de serrage.
